# EUROPÄISCHE PATENTSCHRIFT

(11) **EP 0 879 492 B1**
(45) Veröffentlichungstag und Bekanntmachung des Hinweises auf die Patenterteilung: **21.11.2007**
(21) Anmeldenummer: 97941804.3
(22) Anmeldetag: 22.08.1997
(51) Int. Cl.: H01R 43/02

(54) **ANORDNUNG, INSBESONDERE ZUR VERWENDUNG IN EINEM ELEKTRONISCHEN STEUERGERÄT, UND VERFAHREN ZUR HERSTELLUNG DERSELBEN**
SYSTEM, TO BE USED ESPECIALLY IN AN ELECTRONIC CONTROLLER, AND MANUFACTURE OF SAME
SYSTEME A UTILISER NOTAMMENT DANS UN APPAREIL ELECTRONIQUE, ET MODE DE FABRICATION

(30) Priorität: 29.11.1996 DE 19649549
(43) Veröffentlichungstag der Anmeldung: 25.11.1998
(73) Patentinhaber: ROBERT BOSCH GMBH, 70442 Stuttgart (DE)
(72) Erfinder: HUBER, Elmar, D-72793 Pfullingen (DE); LITZINGER, Rolf, D-72379 Hechingen (DE); RAICA, Thomas, D-72379 Hechingen (DE)
(86) Internationale Anmeldenummer: PCT/DE1997/001810
(87) Internationale Veröffentlichungsnummer: WO 1998/024157

(56) Entgegenhaltungen:
- EP-A- 0 695 117
- DE-A- 4 240 755
- DE-A- 19 507 143
- DE-C- 4 308 898
- US-A- 5 530 287
- PATENT ABSTRACTS OF JAPAN vol. 14, no. 241 (E-931), 22.Mai 1990 & JP 02 066865 A (NEC), 6.März 1990,

## Beschreibung

### Stand der Technik

Die Erfindung betrifft eine Anordnung mit den im Oberbegriff des Anspruchs 1 angegebenen Merkmalen und ein Verfahren nach Anspruch 6 zur Herstellung derselben. Die Merkmale des Oberbegriffs der Ansprüche 1 und 6 sind in DE 43 08 898 C1 offenbart.

Eine derartige Anordnung ist bereits aus der DE 42 40 755 A1 bekannt und wird insbesondere in elektronischen Steuergeräten verwandt. Die Anordnung umfaßt eine Trägerplatte mit einem aufgebrachten Leiterplattensubstrat, das mit einer elektronischen Schaltung und Bauelementen versehenen ist, und ein mit der Trägerplatte verbundenes Steckerteil mit mehreren in einem Isoliermaterial eingebetteten und beidseitig aus dem Steckerteil herausgeführten Steckerstiften. Die Anordnung wird z.B. in einem Kraftfahrzeug an externe Steckverbinder angeschlossen werden, die auf die ersten Enden der Steckerstifte aufsteckbar sind. Die der Leiterplatte zugewandten zweiten Enden der Steckerstifte verlaufen parallel zur Leiterplatte mit senkrecht zur Leiterplatte ausgerichteten Stirnflächen und sind an den gewalzten Seitenflächen über Bonddrähte mit Anschlußflächen auf der Leiterplatte verbunden. Nachteilig hierbei ist, daß bei einer derartigen Anordnung der Raum über den parallel zum Leiterplattensubstrat und der Trägerplatte ausgerichteten Seitenflächen der Steckerstifte freigehalten werden muß, damit das Bondwerkzeug bei der Herstellung der Bondverbindungen auf die Steckerstifte aufgesetzt werden kann. Eine Anordnung der Steckerstifte in mehreren parallelen Reihen ist deshalb nicht möglich, was insbesondere bei Steckerteilen mit sehr vielen Stiften dazu führt, daß die Steckerleiste seitlich erweitert werden muß, wodurch sich die räumlichen Abmessungen des Steckerteils nachteilig vergrößern und ein erheblicher Platzbedarf entsteht. Aufgrund der großen Entfernungen zu den weiter außen liegenden Steckerstiften werden außerdem lediglich Dickdrahtbondverbindung mit einem Drahtdurchmesser von 0,1 bis 0,3 mm auf die gewalzten Steitenflächen der Steckerstifte aufgebondet. Nachteilig hierbei ist, daß die Herstellung von Dickdraht-Bondverbindungen sehr viel mehr Zeit erfordert als die Herstellung von Dünndraht-Bondverbindungen. Darüber hinaus ist z.B. bei der Gehäusung von Hybridschaltkreisen bekannt, die Stirnseiten von Stekkerstiften mit Abkröpfungen oder Plateaus zu versehen, um direkt auf die Plateaus der Steckerstifte bonden zu können. Nachteilig hierbei ist, daß ein zusätzlicher aufwendiger Herstellungsschritt erforderlich ist, und das Steckerteil durch die räumliche Ausdehnung der Abkröpfungen insgesamt vergrößert wird.

### Vorteile der Erfindung

Die erfindungsgemäße Anordnung mit dem Kennzeichen des Anspruchs 1 hat demgegenüber den Vorteil, daß der für den Anschluß des Substrats an die Steckerstifte benötigte Platzbedarf und die Breite des Steckerteils auf einfache Weise erheblich reduziert werden kann. Dies wird erreicht, indem die Bonddrähte direkt auf die fein gestanzten und parallel zum Substrat auf der Trägerplatte ausgerichteteten Stirnflächen der Steckerstifte aufgebondet werden. Die Abstände zwischen den als reine Stanzteile hergestellten Steckerstiften können vorteilhaft so klein gewählt werden, daß die Abmessungen des Rasters der Steckerstifte den Abmessungen des Rasters der Anschlußflächen auf dem Substrat entsprechen. Außerdem kann der Abstand zwischen den Steckerstiften und den Anschlußflächen des Substrats vorteilhaft verringert werden und die Substratgröße verkleinert werden. Hierdurch wird insgesamt eine kleiner, kompakter Aufbau der Anordnung realisiert.

Insbesondere vorteilhaft ist, die Steckerstifte in mehreren parallelen Reihen im Steckerteil anzuordnen, da alle Stirnflächen der Steckerstifte frei zugänglich sind und das Bondwerkzeug bei der Herstellung der Bonddrahtverbindungen von der dem Substrat zugewandten Seite der Trägerplatte her auf die Stirnflächen aufgesetzt werden kann. Durch die Anordnung der Steckerstifte in mehreren parallelen Reihen wird vorteilhaft erreicht, daß die Breite des Rasters der Stirnflächen nicht größer ist als die Breite des Rasters der Anschlußflächen auf dem Substrat, auch dann wenn die Stirnflächen etwas breiter als die Anschlußflächen sind.

Vorteilhaft ist weiterhin, zumindest die Stanzkanten der Steckerstifte mit einer galvanisch aufgebrachten Metallisierung zu beschichten, um die Qualität der Schweißverbindung zwischen Bonddraht und Steckerstift zu erhöhen.

Vorteilhaft für die Herstellung des Steckerteils ist weiterhin, wenn die zweiten Enden der Steckerstifte ein Stück von dem als Spritzgußteil gefertigten Steckerteil abstehen, da dann die Steckerstifte während des Spritzgießen des Steckerteils mit großer Präzision im Spritzgußwerkzeug justiert gehalten werden können.

Vorteilhaft ist außerdem das Steckerteil in einer Ausnehmung der Trägerplatte einzusetzten, da hierdurch die Steckerstifte auf besonders einfache Weise nahe an den Anschlußflächen des Substrats positioniert werden können.

Vorteilhaft ist weiterhin ein Verfahren nach Anspruch 6 zur Herstellung einer Anordnung mit einer Trägerplatte und wenigstens einem darauf aufgebrachten Substrat für elektrische und/oder elektronische Bauelemente und mit einem Steckerteil mit mehreren in Isolierstoff eingebetteten Steckerstiften, deren erste Enden für den Anschluß externer Steckvorrichtungen vorgesehen sind und deren zweite Enden über Bonddrähte mit dem Substrat elektrisch verbunden sind, das folgende Schritte umfaßt: Freistanzen der Steckerstifte aus einem Metallband unter Beibehaltung eines einseitigen die Steckerstifte an ihren ersten Enden verbindenden Querstegs; Feinstanzen der Steckerstifte; Galvanisches Beschichten der Steckerstifte mit einer Kontaktmetallisierung; Entfernen des Querstegs; Einlegen der Steckerstifte in ein Spritzgießwerkzeug und Herstellung des Steckerteils durch Spritzgießen mit einem Isolierstoff; Einsetzen des Steckerteils in eine Ausnehmung der Trägerplatte mit in etwa parallel zu dem Substrat verlaufenden Stirnflächen der Steckerstifte und Herstellen von Bonddrahtverbindungen zwischen den Stirnflächen der einzelnen Steckerstifte und dem Substrat auf der Trägerplatte.

Die Herstellung der Steckerstifte als einfache Stanzteile ist besonders kostengünstig. Durch das Feinstanzen der Stekkerstifte wird vorteilhaft erreicht, daß die Stirnflächen der Steckerstifte die zum Drahtbonden erforderliche Oberflächenqualität aufweisen. Die Steckerstifte werden dabei vorteilhaft über einen einseitigen Verbindungssteg gehalten, der erst nach der anschließenden galvanischen Beschichtung der Steckerstifte entfernt wird.

Besonders vorteilhaft ist die Verwendung von Dünndrahtbondverbindungen mit einem Drahtdurchmesser von 0.025 bis 0.1 mm, deren Herstellung im Vergleich zu den im Stand der Technik üblichen Dickdrahtbondverbindungen sehr viel schneller durchgeführt werden kann.

### Zeichnung

Ein Ausführungsbeispiel der Erfindung ist in der Zeichnung dargestellt und wird in der nachfolgenden Beschreibung näher erläutert. Es zeigt
Fig. 1 einen Ausschnitt einem Querschnitt aus der erfindungsgemäßen Anordnung mit einem Trägerteil und einem Stekkerteil entlang der Linie I-I der Fig. 2,
Fig. 2 einen Ausschnitt aus einer schematischen Draufsicht auf die erfindungsgemäße Anordnung mit einem Trägerteil und einem Steckerteil,
Fig. 3 nach einem ersten Stanzvorgang durch einen einseitigen Quersteg miteinander verbundene Steckerstifte.

### Beschreibung des Ausführungsbeispiels

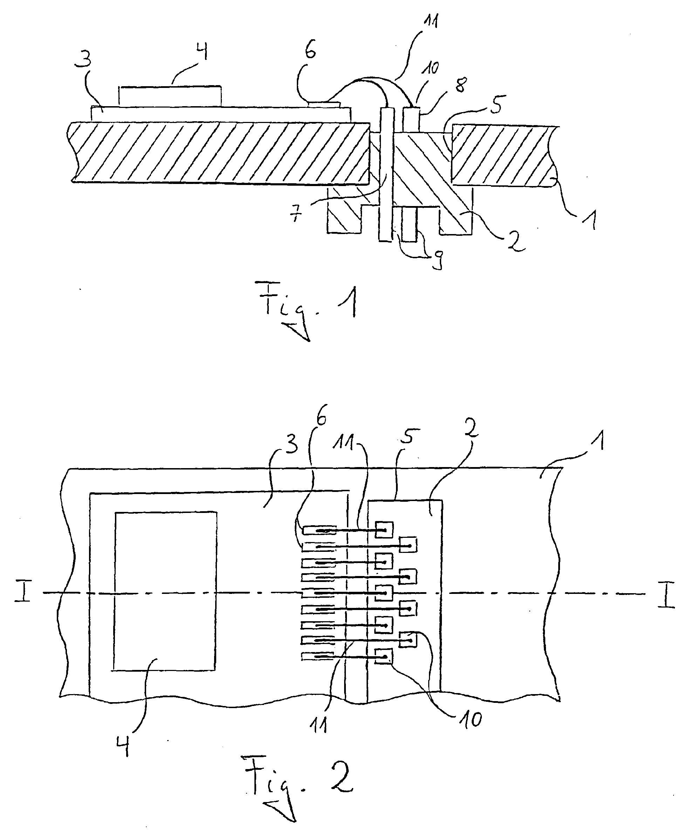

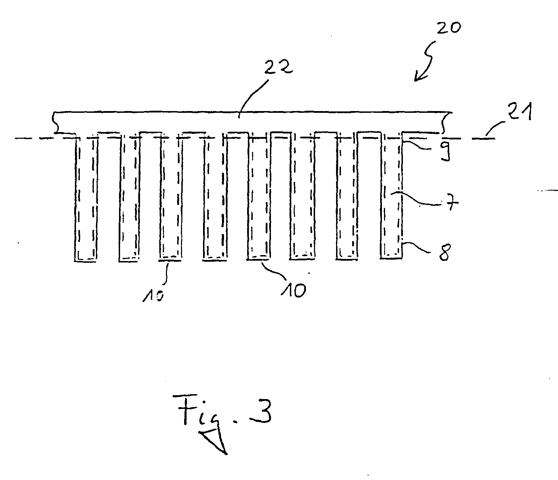

Fig. 1 zeigt einen Querschnitt durch die erfindungsgemäße Anordnung, die z.B. in einem elektronischen Steuergerät eines Kraftfahrzeuges verwandt werden kann. Die Anordnung umfaßt eine Trägerplatte 1, die z.B. den Boden eines Steuergerätes bildet. Auf der Oberseite der Trägerplatte 1 befindet sich ein Substrat 3, das z.B. eine Leiterplatte, ein Hybridkeramiksubstrat oder ein Keramik-Multilayer sein kann. Das Substrat 3 umfaßt eine elektronische Schaltung mit Bauelementen 4, von denen nur eines in Fig. 1 und Fig. 2 gezeigt ist. Die Leiterbahnen, welche die Bauelemente 4 verbinden sind nicht dargestellt. Das Substrat 3 weist mit den Schaltungsteilen und den Bauelementen 4 verbundene Anschlußflächen 6 zum Anschluß an ein Steckerteil 2 auf, welches in einer Ausnehmung 5 der Trägerplatte 1 befestigt ist. Dies kann durch Schrauben, Kleben oder in anderer geeigneter Weise geschehen. Das Steckerteil 2 ist als Spritzgußteil ausgestaltet und weist mehrere in Isolierstoff eingebettete, als einfache Stanzteile hergestellte Steckerstifte 7 auf, die beidseitig aus dem Steckerteil 2 herausgeführt sind. Die Stekkerstifte können z.B. aus galvanisch mit Nickel und Gold beschichtetem CuFe₂ hergestellt sein und weisen einen quadratischen Querschnitt von 0,6 x 0,6 mm auf. Die auf der dem Substrat 3 abgewandten Seite der Trägerplatte 1 aus dem Steckerteil 2 herausgeführten ersten Enden 9 der Steckerstifte 7 sind zum Anschluß an einen externen Gegenstecker vorgesehen, während die auf der dem Substrat zugewandten Oberseite der Trägerplatte 1 abstehenden zweiten Enden 8 zum elektrischen Anschluß an das Substrat 3 vorgesehen sind. Entscheidend ist, daß die Stirnflächen 10 an den zweiten Enden parallel zum Substrat 3 und den Anschlußflächen 6 ausgerichtet sind, damit das Bondwerkzeug an die Stirnflächen 10 und Anschlußflächen 6 herangeführt werden und eine Bonddrahtverbindung zwischen den Stirnflächen 10 und den Anschlußflächen 6 hergestellt werden kann. Die in Fig. 1 und Fig.2 dargestellten Bonddrähte 11, welche die Anschlußflächen 6 des Substrats 3 und die Stirnflächen 10 der Steckerstifte verbinden, können durch Dickdraht- oder Dünndrahtbonden hergestellt sein. Beim Dünndrahtbonden werden Golddrähte mit einem Durchmesser von 0,025 mm bis 0,1 mm verwandt, beim Dickdrahtbonden Aluminiumdrähte mit einem Durchmesser von 0,1 bis 0,3 mm. Die Steckerstifte 7 sind in zwei parallelen Reihen in dem Steckerteil 2 angeordnet. Es sind aber auch Ausführungen mit mehr als zwei Reihen denkbar. Wie insbesondere in Fig. 2 zu erkennen ist, sind die Steckerstifte 7 in dem Steckerteil 2 in zwei hintereinanderliegenden und versetzt zueinander liegenden Reihen angeordnet. Die Abmessungen des Rasters der Stirnflächen 10 korrespondieren zu dem Raster der Anschlußflächen 6 des Substrats 3 derart, daß die Breite des Rasters der Stirnflächen 10 nicht größer als die Breite des Rasters der Anschlußflächen 6 ist und daß sich die Anschlußflächen 6 und die Stirnflächen 10 gegenüberliegen. Hierduch werden die räumlichen Abmessungen der Anordnung vorteilhaft reduziert. Durch die versetzte Anordnung der beiden Reihen der Stirnflächen 10 wird dabei erreicht, daß die Bonddrähte zu den Stirnflächen 10 der weiter entfernt vom Substrat 3 angeordneten Reihe nicht die Stirnflächen 10 der näher am Substrat angeordneten vorderen Reihe überdecken, so daß eine Bonddrahtverbindung zu den vorderen Reihen problemlos hergestellt werden kann. Durch die Art der Anordnung sind die Stirnseiten 10 der Steckerstifte nahe an den Anschlußflächen 6 angeordnet, so daß die Bondverbindung zwischen den beidnen Flächen relativ kurz ist. Es kann daher sowohl mit Dickdraht als auch mit Dünndraht gebondet werden, wobei Dickdraht-Bondverbindungen insbesondere für hochstromige Anschlüsse verwandt werden.

Im folgenden wird ein Verfahren zur Herstellung der oben beschriebenen Anordnung aufgezeigt. Wie in Fig. 3 dargestellt wird die Kontur der Steckerstifte zunächst in einem ersten Stanzschritt (durchgezogene Linie) aus einem Metallband 20 aus z.B. CuFe₂ ausgestanzt, wobei ein einseitiger Quersteg 22 beibehalten wird, der die Steckerstifte an ihren ersten Enden 9 miteinander verbindet. Der Glattschnittanteil beim ersten Stanzen entspricht etwa dem Bruchanteil, so daß die Steckerstifte anschließend in einem Feinstanzschritt nochmals gestanzt werden müssen (gestrichelte Linie in Fig. 3) und nun ihre entgültige Kontur erhalten. Der Glattschnittanteil der Stanzkanten beim zweiten Stanzen ist wesentlich höher, so daß insbesondere die als Bondflächen vorgesehenen Stirnflächen 10 der Steckerstifte 7 eine glatte, bondfähige Oberflächenstruktur erhalten. Anschließend werden die Stekkerstifte zumindest an den Stirnflächen 10 galvanisch mit einer Goldschicht mit Unternickelung überzogen und entlang der Linie 21 in Fig. 3 vereinzelt. Die Stifte 7 werden in ein Spritzgußwerkzeug eingelegt und bis auf die ersten Enden 9 und die zweiten Enden 8 mit einem Isolierstoff umspritzt. Beim Dünndrahtbonden sollten die zweiten Enden 9 nicht mehr als 1 mm von dem Steckerteil abstehen, beim Dickdrahtbonden nicht mehr als 0,5 mm. Das fertige Steckerteil 2 wird in einer Ausnehmung 5 einer Trägerplatte 1 derart befestigt, daß die Stirnflächen 10 an den zweiten Enden 8 der Steckerstifte 7 parallel zu den Anschlußflächen 6 des Substrats 3 ausgerichtet sind. Anschließend werden die Anschlußflächen 6 mit den Stirnflächen 10 über Bondrähte 11 mit einem Bondwerkzeug verbunden.

## Patentansprüche

1. Anordnung, insbesondere zur Verwendung in einem elektronischen Steuergerät, mit einer Trägerplatte (1) und wenigstens einem darauf aufgebrachten Substrat (3) für elektrische und/oder elektronische Bauelemente (4) und mit einem Steckerteil (2) mit mehreren in Isolierstoff eingebetteten Steckerstiften (7), deren erste Enden (9) für den Anschluß externer Steckvorrichtungen vorgesehen sind und deren zweite Enden (8) über Bonddrähte (11) mit dem Substrat (3) elektrisch verbunden sind,
wobei die einzelnen Steckerstifte (7) als Stanzteile hergestellt sind, **dadurch gekennzeichnet, daß** deren zumindest zweite Enden (8) jeweils eine in etwa parallel zu dem Substrat (3) verlaufende und durch einen Feinstanzvorgang hergestellte Stirnfläche (10) aufweisen, und daß die Bonddrähte (11) direkt auf die feingestanzten Stirnflächen (10) der Steckerstifte (7) aufgeschweißt sind.

2. Anordnung nach Anspruch 1, **dadurch gekennzeichnet, daß** die Steckerstifte (7) in wenigstens zwei Reihen in dem Steckerteil (2) angeordnet sind.

3. Anordnung nach Anspruch 1, **dadurch gekennzeichnet, daß** die als Stanzteile hergestellten Steckerstifte (7) zumindest an den Stirnflächen (10) mit einer galvanisch aufgebrachten Metallisierung beschichtet sind.

4. Anordnung nach Anspruch 1, **dadurch gekennzeichnet, daß** die zweiten Enden (8) der Steckerstifte (7) ein Stück von dem als Spritzgußteil gefertigten Steckerteil (2) abstehen.

5. Anordnung nach Anspruch 1, **dadurch gekennzeichnet, daß** das Steckerteil (2) in einer Ausnehmung (5) der Trägerplatte (1) befestigt ist.

6. Verfahren zur Herstellung einer Anordnung, insbesondere zur Verwendung in einem elektronischen Steuergerät, mit einer Trägerplatte (1) und wenigstens einem darauf aufgebrachten Substrat (3) für elektrische und/oder elektronische Bauelemente (4) und mit einem Steckerteil (2) mit mehreren in Isolierstoff eingebetteten Steckerstiften (7), deren erste Enden (9) für den Anschluß externer Steckvorrichtungen vorgesehen sind und deren zweite Enden (8) über Bonddrähte (11) mit dem Substrat (3) elektrisch verbunden sind, **gekennzeichnet durch** folgende Schritte:
- Freistanzen der Steckerstifte (7) aus einem Metallband (20) unter Beibehaltung eines die Steckerstifte (7) an ihren ersten Enden (9) verbindenden Querstegs (22),
- Feinstanzen der Steckerstifte (7), an den Stirnflächen (10) der zweiten Enden (8),
- Galvanisches Beschichten zumindest der Stirnflächen (10) der Steckerstifte (7) mit einer Kontaktmetallisierung,
- Entfernen des Querstegs (22),
- Einlegen der Steckerstifte (7) in ein Spritzgießwerkzeug und Herstellung des Steckerteils (2) **durch** Spritzgießen mit einem isolierstoff,
- Einsetzen des Steckerteils (2) in eine Ausnehmung (5) der Trägerplatte (1) mit in etwa parallel zu dem Substrat (3) verlaufenden Stirnflächen (10) der Steckerstifte (7) und
- Herstellen von Bonddrahtverbindungen (11) zwischen den Stirnflächen (10) der einzelnen Steckerstifte (7) und dem Substrat (3) auf der Trägerplatte (1).

7. Verfahren nach Anspruch 6, **dadurch gekennzeichnet, daß** zum Drahtbonden Dünndraht in einer Stärke von 0,025 bis 0,1 mm verwandt wird..

## Claims

1. System, to be used especially in an electronic controller, comprising a support plate (1) and, provided on it, at least one substrate (3) for electrical and/or electronic components (4) and comprising a plug part (2) with a number of plug pins (7), which are embedded in insulating material and the first ends (9) of which are intended for the connection of external plug-in connections and the second ends (8) of which are electrically connected to the substrate (3) by means of bonding wires (11), the individual plug pins (7) being produced as stamped parts, **characterized in that** at least their second ends (8) respectively have an end face (10) that runs approximately parallel to the substrate (3) and is produced by a fine stamping operation, and **in that** the bonding wires (11) are welded directly on the fine-stamped end faces (10) of the plug pins (7).

2. System according to Claim 1, **characterized in that** the plug pins (7) are arranged in at least two rows in the plug part (2).

3. System according to Claim 1, **characterized in that** the plug pins (7) produced as stamped parts are coated at least on the end faces (10) with a galvanically applied metallization.

4. System according to Claim 1, **characterized in that** the second ends (8) of the plug pins (7) protrude a little from the plug part (2) produced as an injection-moulded part.

5. System according to Claim 1, **characterized in that** the plug part (2) is secured in a clearance (5) in the support plate (1).

6. Method for manufacturing a system, to be used especially in an electronic controller, comprising a support plate (1) and, provided on it, at least one substrate (3) for electrical and/or electronic components (4) and comprising a plug part (2) with a number of plug pins (7), which are embedded in insulating material and the first ends (9) of which are intended for the connection of external plug-in connections and the second ends (8) of which are electrically connected to the substrate (3) by means of bonding wires (11), **characterized by** the following steps:
- stamping free of the plug pins (7) from a metal strip (20) while retaining a cross-piece (22) connecting the plug pins (7) at their first ends (9),
- fine stamping of the plug pins (7) at the end faces (10) of the second ends (8),
- galvanic coating of at least the end faces (10) of the plug pins (7) with a contact metallization,
- removal of the cross-piece (22),
- placement of the plug pins (7) in an injection mould and manufacture of the plug part (2) by injection-moulding with an insulating material,
- insertion of the plug part (2) into a clearance (5) in the support plate (1) with end faces (10) of the plug pins (7) running approximately parallel to the substrate (3), and
- establishment of bonding wire connections (11) between the end faces (10) of the individual plug pins (7) and the substrate (3) on the support plate (1).

7. Method according to Claim 6, **characterized in that** thin wire of a thickness of 0.025 to 0.1 mm is used for the wire bonding.

## Revendications

1. Dispositif notamment destiné à un appareil de commande électronique comprenant une plaque de support (1) portant au moins un substrat (3) pour des composants électriques et/ou électroniques (4) et une partie de connexion (2) à plusieurs broches de connexion (7) intégrées dans de la matière isolante et dont les premières extrémités (9) sont destinées au branchement des dispositifs de connexion, externes et les secondes extrémités (8) sont reliées électriquement par des fils de liaison (11) au substrat (3),
les différentes broches de connexion (7) étant réalisées sous la forme de pièces embouties,
**caractérisé en ce qu'**
au moins les secondes extrémités (8) ont chacune une surface frontale (10) parallèle au substrat (3) et fabriquée par une opération d'emboutissage fin, et
les fils de liaison (11) sont soudés directement sur les surfaces frontales (10) d'emboutissage fin des broches de connexion (7).

2. Dispositif selon la revendication 1,
**caractérisé en ce que**
les broches de connexion (7) sont réparties en au moins deux rangées dans la partie de connexion (2).

3. Dispositif selon la revendication 1,
**caractérisé en ce que**
les broches de connexion (7) réalisées comme pièces embouties sont revêtues au moins au niveau des surfaces frontales (10) par une métallisation appliquée par voie galvanique.

4. Dispositif selon la revendication 1,
**caractérisé en ce que**
les secondes extrémités (8) des broches de connexion (7) sont en saillie d'une certaine longueur de la pièce de connexion (2) fabriquée comme pièce injectée.

5. Dispositif selon la revendication 1,
**caractérisé en ce que**
la pièce de connexion (2) est fixée dans une cavité (5) de la plaque de support (1).

6. Procédé de fabrication d'un dispositif, notamment destiné à un appareil de commande électronique comprenant une plaque de support (1) et sur celle-ci, au moins un substrat (3) pour des composants électriques et/ou électroniques (4) et une pièce de connexion (2) avec des broches de connexion (7) intégrées dans de la matière isolante et dont les premières extrémités (9) sont destinées au branchement de dispositifs externes de connexion et les secondes extrémités (8) sont reliées électriquement par des fils de liaison (11) au substrat (3),
**caractérisé par** les étapes suivantes :
- séparation par emboutissage des broches de connexion (7) dans un ruban métallique (20) en conservant une entretoise transversale (22) reliant les premières extrémités (9) des broches de connexion (7),
- séparation par emboutissage des broches de connexion (7) au niveau des surfaces frontales (10) des secondes extrémités (8),
- revêtement galvanique au moins des surfaces frontales (10) des broches de connexion (7) avec métallisation de contact,
- enlèvement de l'entretoise transversale (22),
- mise en place des broches de connexion (7) dans un outil d'injection et fabrication de la pièce de connexion (2) par injection de matière isolante,
- mise en place de la pièce de connexion (2) dans une cavité (5) de la plaque de support (1) avec des surfaces frontales (10) des broches de connexion (7) sensiblement parallèles au substrat (3) et
- fabrication des liaisons de fils (11) entre les surfaces frontales (10) des broches de connexion séparées (7) et le substrat (3) sur la plaque de support (1).

7. Procédé selon la revendication 6,
**caractérisé en ce que**
pour la liaison par fils on utilise des fils minces d'une épaisseur de 0,025 jusqu'à 0,1 mm.
